Europäisches Patentamt

European Patent Office

Office européen des brevets

(11) Veröffentlichungsnummer: **0 142 738**
**A1**

## EUROPÄISCHE PATENTANMELDUNG

(21) Anmeldenummer: 84112841.6

(22) Anmeldetag: 25.10.84

(51) Int. Cl.⁴: **H 03 K 21/00**

(30) Priorität: 05.11.83 DE 3340110

(43) Veröffentlichungstag der Anmeldung:
29.05.85 Patentblatt 85/22

(84) Benannte Vertragsstaaten:
CH FR GB LI

(71) Anmelder: J. Hengstler K.G.
Uhlandstrasse 49
D-7209 Aldingen - 1(DE)

(72) Erfinder: Oesterle, Wolfgang
Hermann-Löns-Strasse 40
D-7707 Engen(DE)

(72) Erfinder: Halder, Anton
Schubartstrasse 7
D-7735 Dauchingen(DE)

(74) Vertreter: Hubbuch, Helmut, Dipl.-Ing et al,
Patentanwälte Dr. Rudolf Bauer Dipl.-Ing. Helmut
Hubbuch Dipl.-Phys. Ulrich Twelmeier Westliche
Karl-Friedrich-Strasse 29-31
D-7530 Pforzheim(DE)

(54) Elektronik-Zähler.

(57) Die Erfindung betrifft einen programmierbaren Elektronik-Zähler (1) mit Datenspeicher als Vorwahlzähler mit einer Anzahl Tasten (3) zur Eingabe von Vorwahlen und Prorammen sowie Funktionstasten (4) beispielsweise zur Rückstellung des Zählwertes und der Programme. Vorallem bei solchen Zählern mit einer Mehrzahl von mehrstelligen Vorwahlen und bei häufigem Programmwechsel ist die Programmierung, d.h. manuelle Eingabe aller Vorwahlen in richtiger Reihenfolge aufwendig und erfordet besondere Sorgfalt.

Dies wird nun bei dem programmierbaren Elektronik-Zähler (1) mit Datenspeicher gemäß der Erfindung vereinfacht durch eine steckbar angeordnete entnehmund austauschbare Datensteckeinheit (8), die einen Speicher (11), welcher der Datenübernahme und --Speicherung dient, eine Anzahl Schaltschleifen, Zuordnungs-Kodierungen und ein Kennzeichnungsfeld aufweist, wodurch sich Programme, Zählwerte und Vorwahlen die einmal eingegeben sind, in einer entnehmbaren Datensteckeinheit (8) speichern und zusammen mit weiteren Werten erhalten lassen.

Fig 1

- 1 -

## Beschreibung:

Die Erfindung betrifft einen programmierbaren Elektronik-Zähler mit Datenspeicher als Vorwahlzähler mit einer Anzahl Tasten zur Eingabe von Vorwahlen und Programmen sowie Funktionstasten beispielsweise zur Rückstellung des Zählwertes und der Programme.

Vorallem bei solchen Zählern mit einer Mehrzahl von mehrstelligen Vorwahlen und bei häufigem Programmwechsel ist die Programmierung, d.h. manuelle Eingabe aller Vorwahlen in richtiger Reihenfolge aufwendig und erfordert besondere Sorgfalt. Dies macht besonders eingeübtes Bedienungspersonal erforderlich und erschwert die Handhabung und Anwendung solcher programmierbarer Elektronik-Vorwahlzähler erheblich.

Aufgabe der Erfindung ist es, diese Nachteile und Erschwernisse zu vermeiden. Hierzu kennzeichnet sich der programmierbare Elektronik-Zähler mit Datenspeicher gemäß der Erfindung durch eine steckbar angeordnete entnehm- und austauschbare Datensteckeinheit, die einen Speicher, welcher der Datenübernahme und -Speicherung dient, eine Anzahl Schaltschleifen, Zuordnungs-Kodierungen und ein Kennzeichnungsfeld aufweist. Hierdurch lassen sich Programme, Zählwerte und Vorwahlen die einmal eingegeben sind, in einer entnehmbaren Datensteckeinheit speichern und zusammen mit weiteren Werten erhalten. Zur gesicherten Handhabung kann die Datensteckeinheit verriegelbar sein mittels einer Verriegelungseinheit, welcher Funktionsschalter zugeordnet sind, die mit Zuordnungscodierung und/oder Schaltschleifen zusammenwirken.

Außerdem kann der programmierbare Vorwahlzähler eine Aufnahme für die einsteck- und entnehmbare Datensteckeinheit enthalten, wobei die Stecker- und Buchsenleiste in Zähler und Datensteckeinheit vertieft gelegt und dadurch geschützt ist.

Eine weitere vorteilhafte Handhabung ergibt sich dadurch, daß der programmierbare Vorwahlzähler nur in Verbindung mit eingestecktem Datenstecker eine funktionsfähige Einheit bilden, wobei dieser mittels dem eingebauten NV Speicher alle Daten auch gegen Netzausfall sichert. Die jeweilige Neuprogrammierung erfolgt bei eingesteckter Datensteckeinheit mittels der üblichen Tastatur des Zählers, wobei durch den Funktionsschalter ausgelöst, beim Entriegeln der Datensteckeinheit alle Werte unverlierbar abgespeichert werden.

Durch einfaches Austauschen beliebiger Datensteckeinheiten sind jeweils umfangreiche Programmwechsel möglich, was gegenüber sonst üblichen manuellen Eingaben problemloser und rationeller ist.

Weitere Einzelheiten des erfindungsgemäßen programmierbaren Elektronik-Zählers als Vorwahlzähler sind
anhand eines bevorzugten Ausführungsbeispiels in
Zeichnungen dargestellt und nachfolgend beschrieben
und zwar zeigen:

Figur 1    einen programmierbaren Elektronik-
           Vorwahlzähler mit Datensteckeinheit
           in perspektivischer Darstellung,

Figur 2 und 3    verschiedene Einzelheiten der Ver-
                 riegelungseinrichtung der Datensteck-
                 einheit in Prinzipdarstellung,

Figur 4    ein Funktionsblockschaltbild des
           programmierbaren Elektronik-Vorwahlzähler.

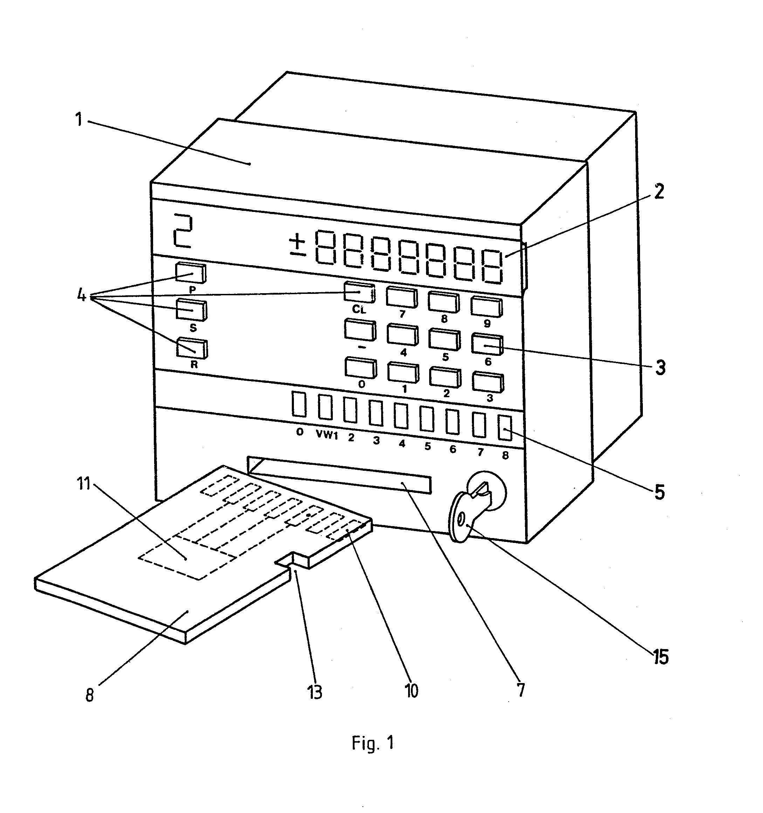

Nach Fig 1 ist im Gehäuse 1 ein programmierbarer
elektronischer Vorwahlzähler eingebaut mit Anzeige 2
und einer Vielzahl von Tasten 3 zur Einstellung des
Vorwahlwertes der jeweiligen Vorwahl, welche in den
weiteren Tasten 4 selektiert und in den Anzeigemittel 5 bei aktivem Ausgang angezeigt wird. Der
jeweils einzustellende Vorwahlwert erscheint in der
Anzeige 2, die nach Inbetriebnahme des Zählers der
Anzeige des auflaufenden Zählwertes dient.

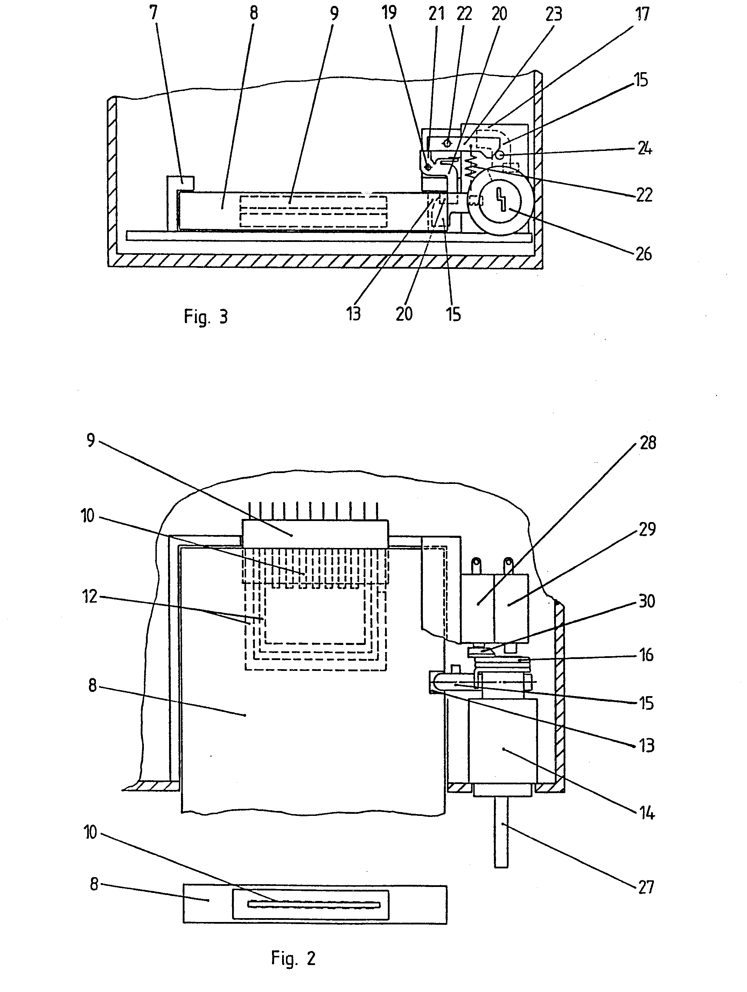

Der Aufnahmeschacht 7 im unteren Teil des Gehäuses 1
dient zur Aufnahme der Datensteckeinheit 8 und enthält tieferliegend angeordnet eine in Fig. 3 sichtbare Kontakt-Federleiste 9 zur steckbaren Verbindung mit den Steckkontakten 10 der Datensteckeinheit 8. Über diese Steckverbindung zwischen der Kontaktfederleiste 9 und den Steckkontakten 10 wird der Zähler durch den in der Datensteckeinheit 8 eingebauten NV Speicher 11 ergänzt und damit funktionsfähig.

Wie nach Fig. 2 und 3 weiter ersichtlich wird, enthält die Datensteckeinheit 8 mehrere Schaltschleifen 12, welche bei berechtigter bzw. übereinstimmender Zuordnung die Betriebsbereitschaft des Zählers sicherstellt, welcher nur bei vorhandener Datensteckeinheit 8 einschaltbar ist. Die Datensteckeinheit 8 enthält außerdem eine Aussparung 13, in welche bei in Betriebsstellung verdrehtem Schlüsselschalter 14 ein Riegel 15 eingreift und diese gegen Entnahme sichert.

Wie in Fig. 3 erkennbar ist, reicht die im Drehpunkt 19 gelagerte Klinke 20, bei entnommener Datensteckeinheit 8 in den Aufnahmeschacht 7 und blockiert mit dem Sperrende 21 den im Drehpunkt 22 gelagerten Sperrhebel 23, welcher am Stift 24 des Riegel 15 anliegend den Schloßzylinder 26 gegen Linksdrehung sperrt.

Bei eingesteckter Datensteckeinheit 8 verschwenkt die Klinke 20 um ihren Drehpunkt 19 zur Freigabe des Sperrhebels 23, wodurch sich der Schloßzylin-

0142788

- 5 -

der 26 unter Wirkung der Feder 16 verdreht bis der Riegel 15 in die Aussparung 13 der Datensteckeinheit 8 zur Sicherung eingreift. Zur weiteren Absicherung gegen nicht berechtigte Benutzung dient außerdem die an sich bekannte Schloßfunktion mit mehreren Zuhaltungen im Zusammenhang mit dem Schlüssel 27, welcher nur in der Stellung mit verriegelter Datensteckeinheit abziehbar ist.

Dem Schlüsselschalter 14 sind zwei Umschalter 28 und 29 zugeordnet, welche mittels Nocken 30 abhängig von der Stellung des Schloßzylinders betätigbar sind. Der Umschalter 28 ist in der Betriebsstellung, wie in Fig. 2 dargestellt, betätigt, wodurch beispielsweise ein Not-Aus-Signal öffnet, und den Zähler nullstellt. Der andere Umschalter 29 schaltet die Netzspannung ein und übernimmt weitere nicht näher dargestellte Signalfunktionen. So löst die durch Schalterbetätigung unterbrechende Netzversorgung die Übertragung aller wichtigen Daten in die Steckeinheit 8 aus bzw. werden bei wieder eingeschalteter bzw. vorhandener Netzversorgung diese Werte wieder in den Zähler eingeschrieben.

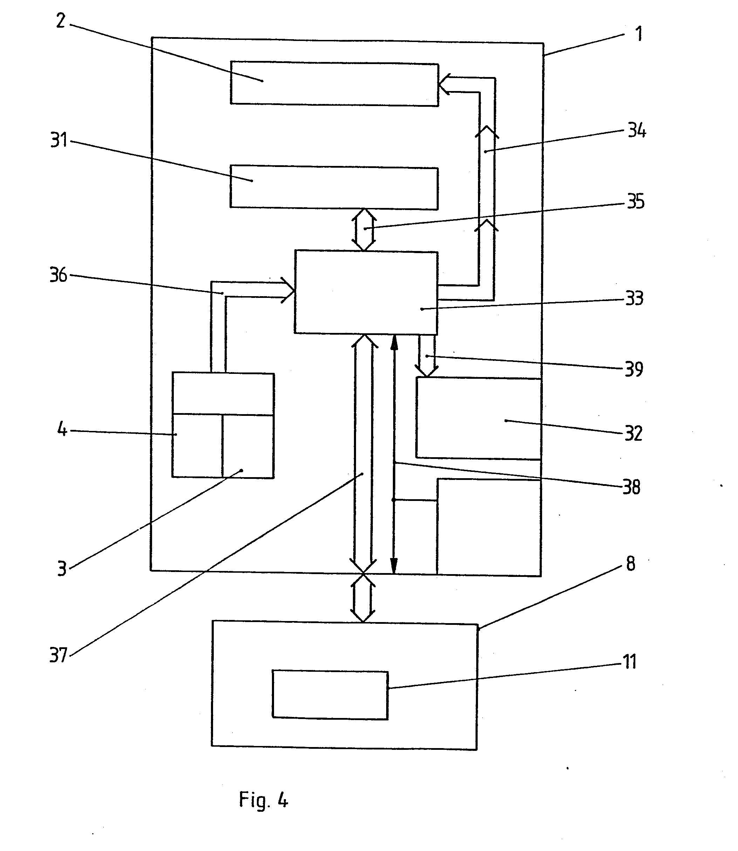

Wie aus dem Funktionsblockschaltbild nach Fig. 4 ersichtlich wird, besteht der Zähler neben den sonst üblichen Bausteinen wie zur Zählung 31 Anzeige 2, Tastatur 3,4 und dem Signalausgang 32, Steuereinheit 33, die über Leitungsverbindungen 36,37,38,39 mit den Bausteinen bzw. den Schaltern 28, 29 und der ggfs. eingesteckten Datensteckeinheit 8 zusammenwirkt. Die Steuereinheit 35 bewirkt, daß eine in den Zähler 1 eingesteckte Datensteckeinheit 8 mittels der Tastatur 33 programmier- bzw. umprogrammierbar ist. Ohne Bedienung der Tastatur 33 überschreibt die Steuereinheit 35 automatisch alle Daten aus der Datensteckeinheit 8 in den Zählerbaustein 31, in die Anzeige 2 und macht den Zähler 1 betriebsbereit.

In der einfachsten Ausstattung sind entsprechende Zähler ohne Tastatur 3,4 ausgeführt, wodurch zwar eine Umprogrammierung nicht mehr direkt möglich ist, vielmehr aber dann in einem Zähler mit Tastatur für mehrere Zählstellen durchgeführt wird.

Auch ein Wechsel umfangreicher Programme an Zähler 1 mit oder ohne Tastatur 3,4 erfolgt mittels Austausch der Datensteckeinheit 8, wobei die Steuereinheit 33 in Verbindung mit Signale des Schlüsselschalters 14 die folgerichtige Übertragung aller wichtigen Daten wie Anzeige, Vorwahl, Programmschritt, Programmart u.a. bewirkt, bevor die Datensteckeinheit 8 entnehmbar ist, oder alle diese Daten folgerichtig von der Datensteckeinheit in den Zähler einschreibt, bevor dessen Betriebsbereitschaft gegeben ist.

PATENTANWÄLTE

# R. RUDOLF BAUER · DIPL.-ING. HELMUT
## DIPL.-PHYS. ULRICH TWELMEIER

0142738

WESTLICHE 29 – 31 (AM LEOPOLDPLATZ)
D-7530 PFORZHEIM (WEST-GERMANY)
☎ (0 72 31) 10 22 90/70 · TELEGRAMME: PATMARK

3. Nov. 1983  II/Be

Fa. J. Hengstler K.G., 7209 Aldingen Kr. Tuttlingen

"Elektronik-Zähler"

Patentansprüche:

1. Programmierbarer Elektronik-Zähler mit Datenspeicher, g e k e n n z e i c h n e t durch eine steckbar angeordnete entnehm- und austauschbare Datensteckeinheit, die einen Speicher, welcher der Datenübernahme und -Speicherung dient, eine Anzahl Schaltschleifen, Zuordnungs-Kodierungen und ein Kennzeichnungsfeld aufweist.

2. Programmierbarer Elektronik-Zähler nach Anspruch 1, d a d u r c h g e k e n n z e i c h n e t, daß derselbe eine verdeckt eingebaute Aufnahme für die Datensteckeinheit mit Verriegelungseinrichtung aufweist, welche mittels Schlüsselschalter oder Freigabesignal verriegel- und entriegelbar ist.

3. Programmierbarer Elektronik-Zähler nach Anspruch 1, d a d u r c h g e k e n n z e i c h n e t , daß die elektrische Steckverbindung zwischen Datensteckeinheit und elektronischem (Vorwahl-)Zähler zur Übertragung aller zur Zählfunktion notwendigen Daten wie Anzeige, Vorwahl, Programmschritt, Programmart dient und Schaltschleifen und/oder Zuordnungs-Kodierungen aufweist.

4. Programmierbarer Elektronik-Zähler nach einem der Ansprüche 1 bis 3, d a d u r c h  g e k e n n z e i c h n e t , daß bei eingesteckter Datensteckeinheit alle Daten und Werte in den Zähler eingegeben und im Zähler anzeigbar sind.

5. Programmierbarer Elektronik-Zähler nach einem der vorhergehenden Ansprüche, d a d u r c h  g e k e n n z e i c h n e t , daß bei Ausfall der Versorgungsspannung des Zählers sämtliche Daten in die Datensteckeinheit überschreib- und dort speicherbar (NV-Speicher) sind.

6. Programmierbarer Elektronik-Zähler nach einem der vorhergehenden Ansprüche, d a d u r c h  g e k e n n z e i c h n e t , daß der Zähler und damit der in der eingesteckten Datensteckeinheit enthaltene Speicher über die Funktionstasten des Zählers vorprogrammierbar ist.

7. Programmierbarer Elektronik-Zähler nach einem der vorhergehenden Ansprüche, d a d u r c h  g e k e n n z e i c h n e t , daß bei Zählern mit Ausführung ohne Funktionstasten, die Programmierung derselben über die Datensteckeinheit bewirkbar ist.

8. Programmierbarer Elektronik-Zähler nach einem der vorhergehenden Ansprüche , d a d u r c h  g e k e n n z e i c h n e t , daß ein mittels Schlüsselschalter und/oder externem Steuerimpuls geschaltete Verriegelungseinrichtung die eingesteckte Daten-

- 3 -

steckeinheit sichert, wobei dem Schlüsselschalter weitere Schalterfunktionen wie Versorgungsspannung ein/aus und Notaussignal zuordenbar sind.

9. Programmierbarer Elektronik-Zähler nach einem der vorhergehenden Ansprüche, d a d u r c h g e k e n n z e i c h n e t , daß die Datensteckeinheit in flachem Gehäuse einerseits den Speicher mit Schaltschleifen aufnimmt und auf der offenen Schmalseite die Steckkontakte und Zuordnungskodierungen gegenüber dem Gehäuseende zurückgesetzt aufweist.

Fig. 1

Fig. 3

Fig. 2

0142738

Fig. 4

## EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 084 082 (P.H. ALFKE) | | H 03 K 21/00 |
| A | DE-A-2 655 095 (K. HEHL)<br>* Anspruch 1; Figur 6 * | | |

RECHERCHIERTE
SACHGEBIETE (Int. Cl.4)

G 05 B 19/12
G 06 M 3/02
H 03 K 21/00

Der vorliegende Recherchenbericht wurde für alle Patentansprüche erstellt.

| Recherchenort | Abschlußdatum der Recherche | Prüfer |
|---|---|---|
| BERLIN | 14-12-1984 | ARENDT M |